# FASCICULE DE BREVET EUROPEEN

(11) **EP 0 593 367 B1**
(45) Date de publication et mention de la délivrance du brevet: **07.01.1999**
(21) Numéro de dépôt: 93402534.7
(22) Date de dépôt: 14.10.1993
(51) Int. Cl.: H01L 21/00, B65G 65/00

(54) **Système de stockage et de transport d'objets plats tels que des boîtes extra-plates et son ratelier portatif**
System zum Transportieren und Speichern von flachen Gegenständen wie extra-flachen Dosen und tragbares Lagergestell dafür
Storing and transport system for flat objects such as extraflat boxes and associated portable rack

(30) Priorité: 16.10.1992 FR 9212424
(43) Date de publication de la demande: 20.04.1994
(73) Titulaire: COMMISSARIAT A L'ENERGIE ATOMIQUE, 75015 Paris (FR)
(72) Inventeur: Doche, Claude, F-38640 Claix (FR)
(74) Mandataire: Dubois-Chabert, Guy

(56) Documents cités:
- EP-A- 0 115 357
- EP-A- 0 302 542
- DE-A- 3 539 957
- US-A- 4 299 518
- US-A- 4 759 681

## Description

### DOMAINE DE L'INVENTION

L'invention concerne le stockage et le transport d'objets plats dans le cadre de leur fabrication ou de leur traitement ou de la fabrication ou le traitement des objets qu'ils contiennent. L'invention s'applique particulièrement à des boîtes extra-plates contenant des tranches de silicium sous atmosphère ultra-propre. Ces tranches ou plaques de silicium sont utilisées pour la fabrication des circuits intégrés dans le domaine de l'électronique et de la microélectronique. Néanmoins, l'invention s'applique à n'importe quel objet plat.

### ART ANTERIEUR ET PROBLEME POSE

Dans le cadre de la fabrication des circuits électroniques sur des plaques circulaires de silicium, les différentes opérations sont effectuées dans des postes de travail sous atmosphère ultra-propre. Or, il est envisagé de manipuler, de stocker et de transporter ces tranches de silicium chacune dans une boite individuelle étanche. Ces dernières sont ouvertes à l'entrée de chaque poste de travail à l'intérieur duquel les objets contenus dans les boîtes sont pris en charge, chaque boîte individuelle restant à l'entrée du poste de travail

Mention est faite du document DE-A-3 539 957 dans lequel est décrit un système selon le préambule de la revendication 1 et des documents US-A-4 759 681 et US-A-4 299 518 dans lesquels sont décrits des systèmes de stockage et de transport d'objet plats avec des râteliers en forme de portique.

On éprouve donc le besoin de savoir stocker, gérer et transporter de manière régulée ces différentes boites extra-plates pour mener à bien la fabrication des circuits électroniques.

Le but de l'invention est donc de proposer un système permettant de transporter et de stocker de manière contrôlée un grand nombre d'objets plats tels que des boîtes extra-plates.

### RESUME DE L'INVENTION

A cet effet, l'objet principal de l'invention est un système de stockage et de transport d'objets plats tel que défini dans la revendication 1.

La réalisation préférentielle des modules de déplacements prévoit que chacun de ces modules est équipé d'au moins deux rouleaux de transport par piste et d'un moteur pour entraîner en rotation les rouleaux.

Cette réalisation comprend de préférence :
- une structure porteuse ;
- deux châssis en H fixes, chacun placé à hauteur d'une piste ;
- deux jeux de deux rouleaux de déplacement pour chaque piste placés entre les branches des châssis en H, les rouleaux étant montés tournants autour d'arbres de rotation débouchant à l'extérieur des châssis en H par une roue d'entraînement recevant une courroie entraînée par le moteur.

De préférence, l'ensemble des deux châssis fixes et le moteur sont montés tournants autour d'un axe vertical pour faire pivoter dans un plan horizontal les deux tronçons de piste.

Une réalisation préférentielle des modules de distribution prévoit qu'ils comprennent un ascenseur de prélèvement des objets sur les deux pistes constituant, lorsqu'il est immobile, une des deux pistes.

L'ascenseur est constitué d'une plate-forme de distribution fixée à un piston vertical monté coulissant dans un piston creux solidaire d'une base porteuse de deux jeux de rouleaux horizontaux, le piston creux étant lui-même monté coulissant verticalement dans un cylindre pour que la base puisse être positionnée tour à tour au niveau des deux pistes, et que la plate-forme puisse être montée à un niveau de distribution.

De préférence, le râtelier portatif possède, dans sa partie inférieure, des moyens de fixation du râtelier sur la partie supérieure du piston et, dans sa partie supérieure, une poignée de manutention équipée de moyens de commande du verrouillage et du déverrouillage des moyens de fixation sur le piston.

Le râtelier constitue d'ailleurs un autre objet principal de l'invention.

### LISTE DES FIGURES

L'invention et ses différentes caractéristiques seront mieux comprises à la lecture de la description suivante qui est illustrée de plusieurs figures représentant respectivement :
- figure 1, système selon l'invention dans son application à un poste de travail sous atmosphère conditionnée ;
- figure 2, un moyen de stockage utilisé dans le système selon l'invention ;
- figure 3, en coupe, un moyen de distribution utilisé dans le système selon l'invention ;
- figure 4, un moyen de transport utilisé dans le système selon l'invention.

### DESCRIPTION DETAILLEE D'UN MODE DE REALISATION

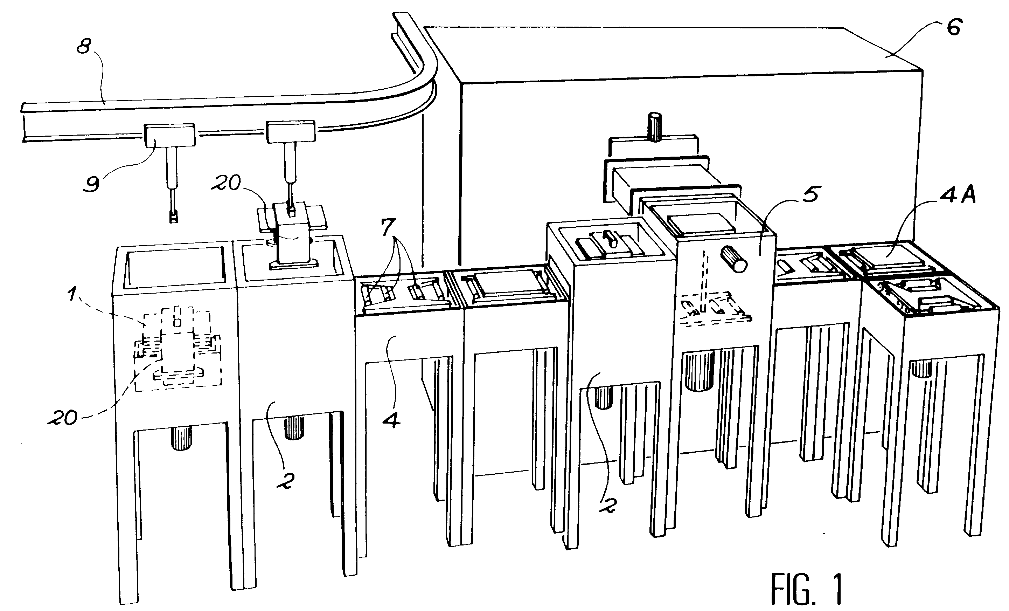

Sur la figure 1, le système selon l'invention est représenté dans son application pour alimenter au moins un poste de travail 6 qui est constitué d'une machine confinée dans un environnement ultrapropre. Le système selon l'invention stocke et transporte des objets plats 1 tels que des boîtes extra-plates. Ces objets plats sont stockés en série et sont transportés pour être expédiés les uns après les autres vers le poste de travail 6.

Dans l'application préférentielle du système de l'invention, ces objets plats 1 sont des boîtes extra-plates contenant des tranches de silicium. Ces dernières sont traitées dans un poste de travail 6 étanche, c'est-à-dire que les tranches de silicium se trouvent confinées dans une atmosphère spéciale. Afin de respecter cette atmosphère, les boîtes extra-plates 1 sont étanches.

Le système selon l'invention comprend donc des moyens de stockage, des moyens de transport et des moyens de distribution des boîtes 1.

Selon l'invention, les moyens de transport sont constitués d'une pluralité de modules de déplacement 4. Les moyens de distribution sont constitués d'autant de modules de distribution 5 qu'il y a de postes de travail 6 à desservir. Les moyens de stockage sont constitués par des modules de stockage 2 pouvant accueillir un râtelier portatif 20 de stockage des boîtes 1.

Tous ces éléments constituent un convoyeur bidirectionnel, c'est-à-dire pouvant transporter les boîtes 1 en deux directions opposées. Pour cela, ces différents éléments sont placés les uns contre les autres de manière à constituer une chaîne continue dont chaque élément est un maillon. En effet, chacun de ces éléments possèdent des rouleaux de transport 7 placés dans deux plans horizontaux différents, parallèles les uns aux autres de manière à constituer deux pistes roulantes continues. L'écart entre chaque rouleau 7 est bien entendu inférieur à la longueur ou la largeur des boîtes 1 transportées. De la sorte, chaque boîte 1 peut être véhiculée d'un module à l'autre tout en suivant une piste continue. Comme le montre le module référencé 4A, placé sur la droite de la figure 1, la chaîne continue peut comporter des changements de direction si les modules adjacents sont placés sur des faces non opposées.

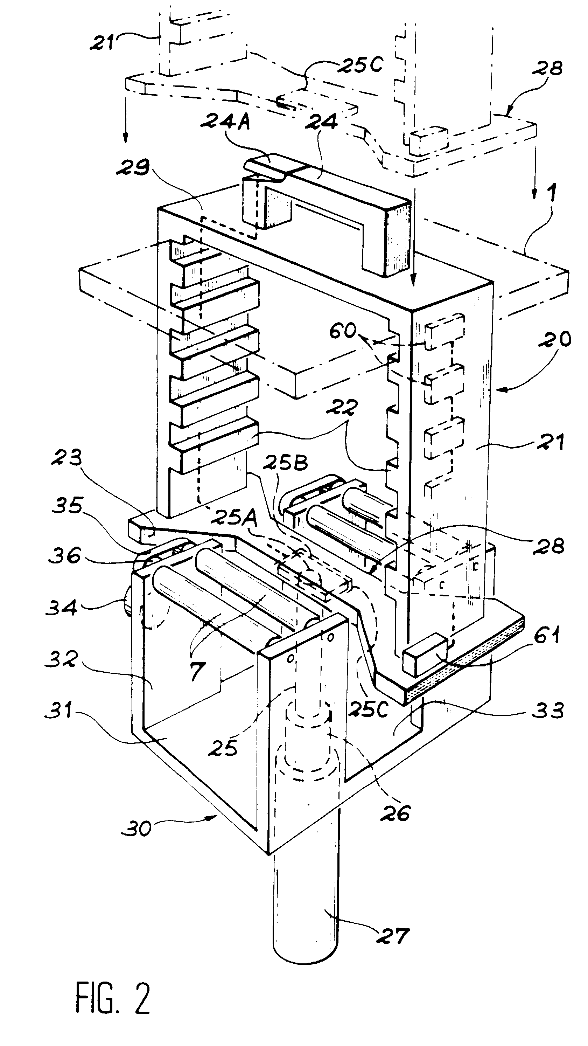

En référence à la figure 2, les modules de stockage 2 de la figure 1 constituant les moyens de stockage peuvent être réalisés de la façon suivante. Sur cette figure 2, l'enveloppe externe de la structure du module de stockage a été enlevée. On y distingue un râtelier portatif 20 destiné à supporter un nombre déterminé de boîtes plates 1 au moyen de rayonnages 22 parallèles entre eux. Ce râtelier portatif 20 fait partie du système, mais constitue également un élément indépendant, en ce sens qu'il peut être déplacé et utilisé en dehors du système. Il est constitué d'une structure en portique 21, les rayonnages 22 étant placés sur les montants verticaux de cette structure 21 du râtelier portatif 20.

Une poignée de manutention 24 peut être prévue sur la partie supérieure 29 de la structure 21.

La base 23 de cette structure 21 a une partie centrale 28 plus étroite que les extrémités de cette base 23. Les évidements ménagés par cette partie centrale étroite 28 de la base 23 permettent de créer un espace dans lequel peuvent être translatés verticalement les rouleaux 7 de ce module de stockage.

En effet, chaque module de stockage devant comprendre des rouleaux 7 permettant de déplacer horizontalement les boîtes 1, on prévoit un châssis 30 en forme de U, que ce soit vu de face ou de côté. En d'autres termes, ce châssis 30 comprend une base 31 plate sur laquelle sont fixés deux à deux quatre montants verticaux 32. Ils sont écartés deux à deux pour permettre le montage de rouleaux parallèles 7 entre deux montants 32 selon une première direction. Ces rouleaux 7 sont montés horizontaux et tournants entre deux montants 32. D'autre part, selon une direction perpendiculaire, deux montants 32 sont également écartés l'un de l'autre d'un espace 33 dont la largeur est supérieure à la largeur de la partie centrale 28 de la base 23 du râtelier portatif 20. On comprend alors qu'une translation en descente verticale du râtelier portatif 20 à l'intérieur du châssis 30, la base 23 pénétrant dans l'espace 33, les rouleaux 7 peuvent être montés à la hauteur de n'importe quel rayonnage 22 du râtelier portatif 20. Ainsi, n'importe quelle boîte plate 1 placée dans un rayonnage 22 pourra être atteinte par les rouleaux 7, et soulevée par ces derniers, dès l'instant qu'il n'y a pas d'autres boîtes en dessous d'elle. L'entraînement en rotation de deux rouleaux 7 se fait au moyen d'un moteur 34 placé sur le montant correspondant 32, entraînant par une courroie d'entraînement 35 des roues d'entraînement 36 solidaires en rotation des rouleaux 7.

Le râtelier portatif 20 est donc mobile, grâce à la poignée de manutention 24 et peut être détaché du reste du module de stockage. De même, ce râtelier portatif 20 peut être posé sur une partie du reste du module de stockage constitué par un plateau 25B placé au sommet 25A d'un piston 25. Ce dernier est monté lui-même coulissant à l'intérieur d'un piston creux 26 vertical solidaire de la base 31 du châssis 30.

On peut prévoir le verrouillage du râtelier portatif 20 sur le plateau 25B du piston 25 par un moyen de fixation qui peut être un système d'encliquetage mécanique 25C. A cet effet, la poignée de manutention 24 peut comporter des moyens de commande 24A du verrouillage et du verrouillage d'un tel moyen de fixation du râtelier portatif 20 sur le piston 25.

D'autre part, le piston creux 26 est monté coulissant à l'intérieur d'un cylindre 27. Ce dernier est fixe dans la structure du module de stockage. Ainsi, à la fois le râtelier portatif 20 et le châssis 30 sont mobiles en translation l'un par rapport à l'autre mais également par rapport au module de stockage dans lequel ils sont placés. De ce fait, les rouleaux 7 peuvent être placés au niveau des rouleaux des deux pistes des deux modules adjacents pour constituer les rouleaux intermédiaires pour une piste, entre les deux modules adjacents. De même, les boîtes plates 1 placées dans les rayonnages 22 du râtelier portatif 20 peuvent toutes être descendues sur les rouleaux 7 lorsqu'ils sont placés au niveau des deux pistes.

En d'autres termes, la boîte plate 1 la plus basse dans les rayonnages 22 du râtelier portatif 20 peut toujours être placée sur les rouleaux 7 et être expédiée sur l'une des deux pistes superposées.

Il est avantageux de prévoir sur la structure 21 du râtelier portatif 20, à chaque étage et en regard du rayonnage 22, un dispositif de verrouillage et de déverrouillage 60 de l'objet stocké dans le rayonnage correspondant. Ces différents dispositifs de verrouillage et de déverrouillage 60 peuvent être placés à l'extérieur de la structure 21, les uns en dessous des autres. Ils peuvent être du type électromécanique ou électromagnétique. Ils peuvent être commandés par des moyens de commande et de gestion centraux du système par l'intermédiaire d'une prise 61, placée par exemple sur la base 28 du râtelier portatif 20 et pouvant être connectée à une prise correspondante du système de commande central. Il est ainsi possible de commander la libération ou le verrouillage d'un des objets stockés sur les rayonnages du râtelier portatif 20.

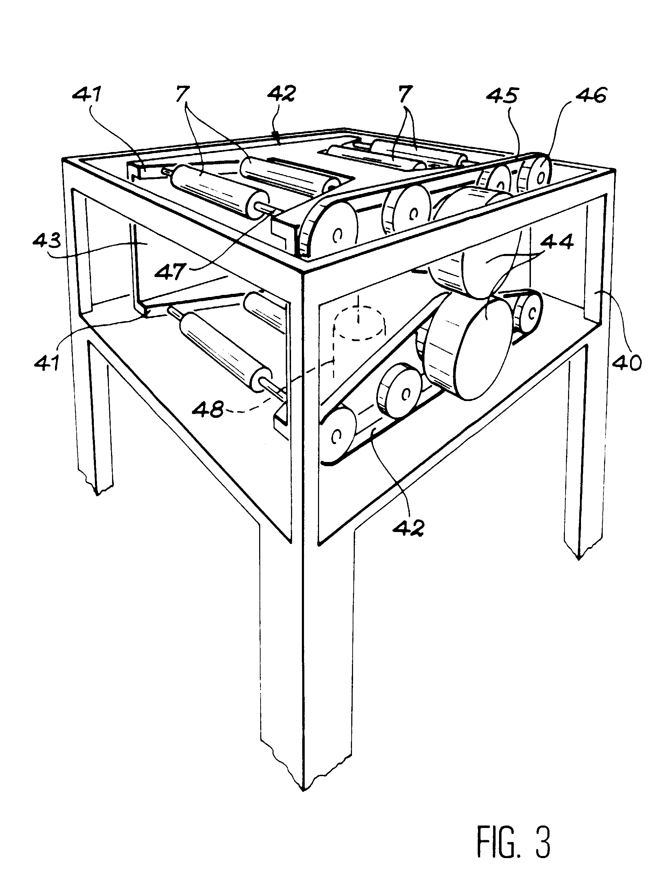

En se référant à la figure 3, les modules de déplacement 4 et 4A sont réalisés de préférence de la façon suivante. Une structure principale 40 parallélépipédique englobe les éléments opérationnels de ce module de déplacement. Ce dernier comprend principalement, au niveau des deux pistes, deux jeux de rouleaux 7, parallèles et montés tournants autour d'un axe horizontal entre les branches 41 d'une plate-forme en H 42 horizontale. Etant donné qu'il y a deux pistes superposées, on utilise deux plate-formes 42 horizontales et parallèles, solidaires l'une de l'autre par des montants verticaux 43. On obtient ainsi deux étages de rouleaux 7 correspondant aux deux niveaux des deux pistes du convoyeur que constituent ces modules de déplacement, les modules de stockage et les modules de distribution.

Les rouleaux 7 d'un étage sont entraînés par un moteur 44, par l'intermédiaire d'une courroie de transmission 45 et d'une roue d'entraînement 46 placée à l'extrémité de chaque arbre 47 autour duquel est monté tournant un rouleau 7. Le moteur 44 entraîne, soit une des roues d'entraînement 46, soit directement la courroie d'entraînement 45. On a représenté deux moteurs 44, un seul moteur pouvant être envisagé par module de déplacement.

La figure 1 montre sur sa droite un module de déplacement 4A constituant un changement de direction de 90° pour les deux pistes du convoyeur. Dans ce cas, chaque module de déplacement comprend un arbre de rotation vertical 48, solidaire de la structure en H constituée des montants 43 et des plate-formes 42 et monté tournant dans la structure 40 du module de déplacement. Ainsi, l'ensemble des rouleaux 7 des deux niveaux, peut être placé dans toutes les directions, notamment, les directions perpendiculaires les unes aux autres pour constituer un changement de direction de 90°.

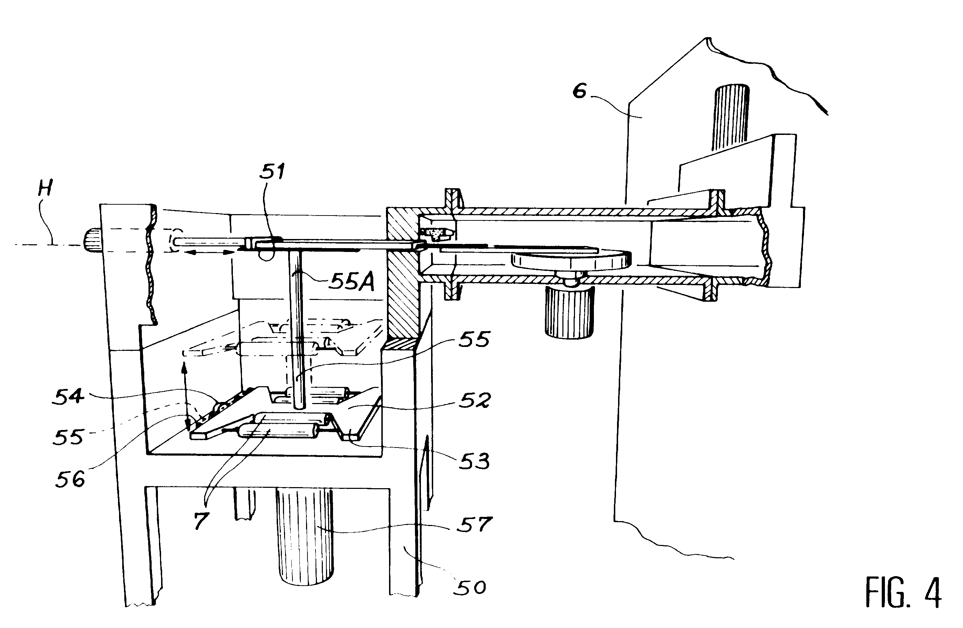

La figure 4 représente en coupe un module de distribution du système selon l'invention qui comporte également un étage de rouleaux 7 pouvant être placé au niveau des deux pistes du convoyeur. Un tel module de distribution comprend une structure extérieure 50 à l'intérieur duquel est montée mobile verticalement une base en H 52 supportant deux jeux de deux rouleaux 7. Ces derniers sont montés tournants horizontalement entre les branches 53 de la base en H 52. L'ensemble est complété d'un moteur 54 entraînant en rotation un ensemble constitué d'une courroie 55 et de roues d'entraînement 56 placées chacune à l'extrémité d'un arbre solidaire en rotation d'un rouleau 7. Cet ensemble est monté mobile verticalement grâce à un piston creux non représenté monté lui-même coulissant à l'intérieur d'un cylindre 57. A l'intérieur de ce dernier, est également monté coulissant un piston 55 à l'extrémité 55A duquel est fixée une plate-forme de distribution 51. En fait, la plate-forme de distribution 51 et la base 52 sont montées mobiles en translation d'une manière analogue au râtelier portatif 20 et au châssis 30 d'un module de stockage. Le piston 55 et la plate-forme 51 constitue un ascenseur pour les objets plats.

Il est donc possible de mettre les rouleaux 7 au niveau des deux pistes du convoyeur, la plate-forme de distribution 51 étant collée contre la base 52. On signale à ce sujet que cette plate-forme de distribution 51 est mince, de manière à ne pas dépasser par rapport aux rouleaux 7, lorsqu'elle est plaquée contre la base 52. De cette manière, les rouleaux 7 peuvent assurés la continuité des deux pistes du convoyeur.

Par contre, lorsqu'il s'agit d'envoyer une boîte plate 1 à l'entrée d'un poste de travail 6, la plate-forme de distribution 51 est montée en soulevant la boîte 1 en question pour la hisser jusqu'au niveau H auquel elle est prise en charge par des organes externes.

Les moteurs et les pistons sont commandés par des moyens de commande et de gestion du stockage, du transport et de la distribution des boîtes plates 1. Il est ainsi possible de gérer le stockage et la distribution vers différents postes de travail 6 d'un grand nombre de boîtes plates 1 au moyen du système selon l'invention.

N'importe quel module de stockage 2 peut être placé entre des modules de déplacement 4 et des modules de distribution 5 pour constituer un stockage tampon entre deux étapes de traitement ou de transport des boîtes. Il est ainsi possible de construire n'importe quel parcours de convoyage à l'intérieur d'un atelier entre différents postes de travail 6.

Le système selon l'invention a été décrit avec des boîtes plates. On rappelle que ces boîtes plates sont destinées à contenir chacune une tranche ou une plaque de silicium sur laquelle doivent être fabriqués des circuits intégrés dans des conditions de travail et de propreté très pointues.

D'autres applications peuvent être prévues pour n'importe quel objet plat dès l'instant que les rayonnages des râteliers portatifs et que l'écartement des rouleaux sont prévus en conséquence.

## Revendications

1. Système de stockage et de transport d'objets plats (1) destiné à alimenter un ou plusieurs endroit(s) (6) en objets (1), ces objets étant transportés un par un, le système comprenant :
- des modules de stockage (2) en groupe des objets plats (1) ;
- des modules de transport (4) un par un des objets plats (1) stockés dans les modules de stockage, constitutant un convoyeur bidirectionnel comportant deux pistes avançant dans deux sens opposés et comprenant une portion élémentaire de chaque piste ;
- des modules de distribution (5) des objets plats (1) transportés par les modules de transport, le système étant caractérisé en ce que :
- les modules de stockage des objets (1) comprennent chacun :
. une structure fixe (27) ;
. un châssis (30) constitué de deux montants parallèles en forme de U (32) au sommet desquels se trouvent au moins deux rouleaux (7) pour le transport des objets plats débouchant à l'extérieur des montants (32) par une roue d'entraînement (36) recevant elle-même une courroie (35) entraînée par un moteur (34), ce châssis (30) étant monté mobile verticalement dans la structure fixe (27) ;
. un râtelier portatif (20) sous la forme d'une structure en cadre comportant une structure en portique (21) terminée par une base (23) ayant une partie centrale (28) étroite, une partie supérieure (29), des rayonnages (22) placés à l'intérieur de la structure (21) pour recevoir les objets plats (1) et une poignée (24), les évidements ménagés par la partie centrale (28) étroite créant un espace dans lequel peuvent être translatés verticalement lesdits rouleaux (7); et
. un piston (25) monté mobile et coulissant dans un piston creux (26) solidaire du châssis (30) pour recevoir le râtelier portatif (20),
tous ces modules (2, 4, 4A, 5) étant placés les uns à côté des autres pour constituer les deux pistes.

2. Système selon la revendication 1, caractérisé en ce que les modules de déplacement (4) sont équipés chacun d'au moins deux rouleaux de transport (7) par piste et d'un moteur (44) pour entraîner en rotation les rouleaux (7).

3. Système selon la revendication 2, caractérisé en ce que les modules de déplacement (4) comprennent :
- une structure porteuse (40) ;
- deux châssis (42) fixe en translation verticale, chaque châssis (42) étant positionné à hauteur d'une piste ;
- deux jeux de deux rouleaux (7) pour chaque piste placés entre les branches (41) des châssis en H (42), les rouleaux (7) étant montés tournants autour d'arbres de rotation débouchant à l'extérieur des branches (41) par une roue d'entraînement (46) recevant une courroie (45) entraînée par le moteur (44).

4. Système selon la revendication 3, caractérisé en ce que l'ensemble des deux châssis (42) est monté tournant autour d'un axe vertical pour faire pivoter dans un plan horizontal les deux tronçons de piste.

5. Système selon la revendication 1, caractérisé en ce que les modules de distribution comprennent un ascenseur de prélèvement des objets plats (1) sur les deux pistes.

6. Système selon la revendication 5, caractérisé en ce que l'ascenseur est constitué d'une plate-forme de distribution (51) fixée à un piston vertical (55) monté coulissant dans un piston creux solidaire d'une base (52) porteuse de deux jeux de rouleaux horizontaux (7), le piston creux étant lui-même monté coulissant verticalement dans un cylindre (57) pour que la base (52) puisse être positionnée tour à tour au niveau des deux pistes, et que la plate-forme (51) puisse être montée à un niveau de distribution (H).

7. Système selon la revendication 1, caractérisé en ce que le râtelier portatif (20) possède, à sa partie inférieure, des moyens de fixation temporaire sur le sommet du piston (25A) et, sur sa partie supérieure, une poignée de manutention (24) équipée de moyens de commande (24A) du verrouillage et du déverrouillage des moyens de fixation du râtelier portatif (20) sur le sommet du piston (25A).

8. Râtelier portatif (20) pour le transport d'objets plats (1) et l'alimentation d'un système de stockage et de distribution de ces objets plats (1) un par un vers des postes de travail différents (6) comportant une structure en cadre comportant une structure en portique (21) terminée par une base (23) ayant une partie centrale (28) étroite, une partie supérieure (29), des rayonnages (22) placés à l'intérieur de la structure (21) pour recevoir les objets plats (1), une poignée (24),
un système d'encliquetage (25C) sur un plateau (25B) du système de stockage et de distribution et des moyens de commande (24A) du verrouillage et du déverrouillage du système d'encliquetage (25C) placés sur la poignée (24), placée elle-même sur la partie supérieure (29).

## Claims

1. System for the storage and transportation of flat objects (1) for supplying one or more locations (6) with objects, said objects being individually transported, said system comprising:
- groupwise storage modules (2) for flat objects (1),
- modules (4) for the individual transportation of the flat objects (1) stored in storage modules and constituting a bidirectional conveyor having two tracks advancing in two opposite directions and comprising an elementary portion of each track,
- modules (5) for the distribution of the flat objects (1) transported by the transportation modules, the system being characterized in that:
- the storage modules for the objects (1) in each case comprise:
- a fixed structure (27),
- a chassis (30) constituted by two parallel, U-shaped uprights (32) at the top of which are provided at least two rollers (7) for the transportation of the flat objects, issuing outside the uprights (32) by a driving wheel (36), which itself receives a belt (35) driven by a motor (34), said chassis (30) being installed in vertically mobile manner in the fixed structure (27),
- a portable rack (20) in the form of a frame structure comprising a gantry structure (21) terminated by a base (23) having a narrow, central portion (28), an upper portion (29), shelves (22) placed within the structure (21) for receiving the flat objects (1) and a handle (24), the recesses provided by the central, narrow portion (28) creating a space into which can be vertically translated the said rollers (7),
- a piston (25) mounted in mobile manner and sliding in a hollow piston (26) integral with the chassis (30) for receiving the portable rack (20),
- all these modules (2, 4, 4A, 5) being placed alongside one another for constituting the two tracks.

2. System according to claim 1, characterized in that each of the displacement modules (4) is equipped with at least two conveying rollers (7) per track and a motor (44) for rotating the rollers (7).

3. System according to claim 2, characterized in that the displacement modules (4) comprise a carrying structure (40), two chassis (42) fixed in vertical translation, each chassis (42) being positioned level with a track, two sets of two rollers (7) for each track placed between the branches (41) of the H chassis (42), the rollers (7) rotating about rotation shafts issuing outside the branches (41) by a driving wheel (46) receiving a belt (45) driven by the motor (44).

4. System according to claim 3, characterized in that the assembly of the two chassis (42) rotates about a vertical axis in order to pivot the two track portions in a horizontal plane.

5. System according to claim 1, characterized in that the distribution modules incorporate an elevator for sampling flat objects (1) on the two tracks.

6. System according to claim 5, characterized in that the elevator is constituted by a distribution platform (51) fixed to a vertical piston (55) slidingly mounted in a hollow piston integral with a carrying base (52) of two sets of horizontal rollers (7), the hollow piston being mounted so as to slide vertically in a cylinder (57) in such a way that the base (52) can in turn be positioned level with the two tracks and that the platform (51) can be installed at a distribution level (H).

7. System according to claim 1, characterized in that, in its lower part, the portable rack (20) has means for the temporary fixing to the top of the piston (25A) and to its upper part of a handling handle (24) equipped with means (24A) for controlling the locking and unlocking of the means for fixing the portable rack (20) to the top of the piston (25A).

8. Portable rack (20) for conveying flat objects (1) and supplying a storage and distribution system of said flat objects (1) individually to different working stations (6) having a frame structure comprising a gantry structure (21) terminated by a base (23) having a narrow central part (28), an upper part (29), shelves (22) located within the structure (21) for receiving the flat objects (1) and a handle (24), a catch system (25C) on a plate (25B) of the storage and distribution system and means (24A) for controlling the locking and unlocking of the catch system (25C) located on the handle (24), which is placed on the upper part (29).

## Patentansprüche

1. System zum Speichern und Transportieren von flachen Gegenständen (1), um einen Ort (6) oder mehrere mit Gegenständen (1) zu versorgen, wobei diese Gegenstände einzeln transportiert werden, umfassend:
- Speichermodule (2), um die flachen Gegenstände (1) gruppenweise zu speichern;
- Transportmodule (4), um die in den Speichermodulen gespeicherten flachen Gegenstände (1) einzeln zu transportieren, eine Zweirichtungs-Fördereinrichtung mit zwei sich in entgegengesetzte Richtungen vorwärtsbewegenden Bahnen bildend und einen elementaren Teil jeder Bahn umfassend;
- Verteilungsmodule (5) der durch die Transportmodule transportierten flachen Gegenstände (1),
wobei das System **dadurch gekennzeichnet** ist, daß jeder der Speichermodule der flachen Gegenstände (1) umfaßt:
. eine feststehende Struktur (27);
. ein Gestell (30), gebildet durch zwei parallele U-förmige Stützen (32), an deren Oberseite sich wenigstens zwei Rollen (7) für den Transport der flachen Gegenstände (1) befinden, mit einem Antriebsrad (36) außerhalb der Stützen (32), selbst über einen Riemen (35) durch einen Motor (34) angetrieben, wobei dieses Gestell (30) vertikal verschiebbar auf die Struktur (27) montiert ist;
. ein tragbares Rack (20) in Form eines Rahmens mit einer Portalstruktur (21), ein Unterteil (23) mit einem schmalen Mittelteil (28) und ein Oberteil (29) mit Etagen (22) zur Aufnahme der flachen Gegenstände (1) im Innern der Struktur (21) sowie einen Griff (24) umfassend, wobei die in dem schmalen Mittelteil (28) vorgesehenen Einbauchungen einen Raum schaffen, in dem die genannten Rollen (7) vertikal verschoben werden können; und
. einen Kolben (25) zur Aufnahme des tragbaren Racks (20), der in einem mit dem Gestell (30) fest verbundenen hohlen Kolben (26) verschiebbar ist,
wobei alle diese Module (2, 4, 4A, 5) nebeneinander angeordnet sind, um die beiden Bahnen zu bilden.

2. System nach Anspruch 1, dadurch gekennzeichnet, daß jeder der Transportmodule (4) mit wenigstens zwei Transportrollen (7) pro Bahn und mit einem Motor (44) zum Antreiben der Rollen (7) ausgerüstet ist.

3. System nach Anspruch 2, dadurch gekennzeichnet, daß die Transportmodule (4) umfassen:
- eine Tragstruktur (40);
- zwei vertikal feststehende Rahmen (42), wobei jeder Rahmen (42) in Höhe einer Bahn positioniert ist;
- zwei Sätze Rollen (7) für jede Bahn, angebracht zwischen den Armen (41) der H-förmigen Rahmen (42), wobei die Rollen (7) sich um Rotationsachsen drehen, auf die außerhalb der Arme (41) ein Antriebsrad (46) montiert ist, das selbst über einen Riemen (45) durch einen Motor (44) angetrieben wird.

4. System nach Anspruch 3, dadurch gekennzeichnet, daß die Einheit aus den beiden Rahmen (42) um eine vertikale Achse drehbar ist, um die beiden Bahnteilstücke schwenkbar zu machen.

5. System nach Anspruch 1, dadurch gekennzeichnet, daß die Verteilungsmodule eine Hebeeinrichtung zur Entnahme der flachen Gegenstände (1) auf den beiden Bahnen umfaßt.

6. System nach Anspruch 5, dadurch gekennzeichnet, daß die Hebeeinrichtung gebildet wird durch eine Verteilungsplattform (51), befestigt an einem vertikalen Kolben (55), gleitend verschiebbar in einem hohlen Kolben, der fest mit einem Unterteil (52) mit zwei Sätzen horizontaler Rollen (7) verbunden ist, wobei der hohle Kolben selbst vertikal in einem Zylinder (57) verschiebbar ist, damit das Unterteil (52) abwechselnd in Höhe der beiden Bahnen positioniert werden kann und die Plattform (51) auf eine Verteilungsebene (H) angehoben werden kann.

7. System nach Anspruch 1, dadurch gekennzeichnet, daß das tragbare Rack (20) an seinem Unterteil Einrichtungen zur temporären Befestigung an der Oberseite des Kolbens (25A) und an seinem Oberteil einen Handhabungsgriff (24) umfaßt, der mit Betätigungseinrichtungen (24A) zum Verriegeln und Entriegeln der Befestigungseinrichtungen des tragbaren Racks (20) am Oberteil des Kolbens (25A) ausgerüstet ist.

8. Tragbares Rack (20) für flache Gegenstände (1), um ein Speicher- und Verteilsystem zu versorgen, das diese flachen Gegenstände (1) einzeln verschiedenen Arbeitsstationen (6) zuteilt, eine Portalstruktur (21) mit einem Unterteil (23) mit schmalem Mittelteil (28) und ein Oberteil (29) mit Etagen (22) zur Aufnahme der flachen Gegenstände (1) im Innern der Struktur (21) umfassend und einen Griff (24) sowie ein Einrast-System (25C) auf einer Platte (25B) des Speicher- und Verteilsystems, und Betätigungseinrichtungen (24A) zur Verriegelung und Entriegelung des Einrastsystems (25C), die sich an dem Griff genannten (24) befinden, der an dem Oberteil (29) befestigt ist.
